# EUROPEAN PATENT APPLICATION

(11) **EP 2 395 822 A1**
(43) Date of publication of application: **14.12.2011**
(21) Application number: 11160078.9
(22) Date of filing: 28.03.2011
(51) Int. Cl.: H05K 3/32

(54) **Mounting structure, electronic component, circuit board, board assembly, electronic device, and stress relaxation member**

(30) Priority: 10.06.2010 JP 2010133371
(71) Applicant: FUJITSU LIMITED, Kawasaki-shi, Kanagawa 211-8588 (JP)
(72) Inventor: Okada, Toru, Kawasaki-shi Kanagawa 211-8588 (JP); Kobayashi, Hiroshi, Kawasaki-shi Kanagawa 211-8588 (JP); Emoto, Satoshi, Kawasaki-shi Kanagawa 211-8588 (JP); Kitajima, Masayuki, Kawasaki-shi Kanagawa 211-8588 (JP)
(74) Representative: Wilding, Frances Ward

(57) **Abstract**

Disclosed is a mounting structure for mounting an electronic component (10) on a circuit board (18). The mounting structure includes an interposer (16) provided between the electronic component and the circuit board; and a plurality of spiral conductors (14) formed in the interposer. The plurality of spiral conductors have one end thereof bonded to corresponding one of external connection terminals (12) of the electronic component and the other end thereof bonded to corresponding one of electrodes (10a) of the electronic component.

## Description

### FIELD

The embodiment discussed herein is related to a mounting structure for mounting an electronic component on a board.

### BACKGROUND

In many cases, electronic devices incorporate circuit boards on which electronic components such as semiconductor devices are mounted. With recent progress in miniaturization of the electronic devices, the circuit boards incorporated into the electronic devices have been miniaturized by high density mounting and the electronic components such as the semiconductor devices mounted on the circuit boards have been also miniaturized. Accordingly, mounting structures for mounting the electronic components on the circuit boards have been also miniaturized.

As bonding members for mounting the semiconductor devices on the circuit boards, solder bumps are often used. Solder bonding using the solder bumps provides electrical connections and mechanically fixes the semiconductor devices to the circuit boards. Where the mounting structures are miniaturized as described above and the solder bumps are made small, solder bonding parts are also made small. Therefore, the solder bump bonding parts are easily deformed and damaged due to thermal stress and external pressure, which results in poor connections being prone to occur.

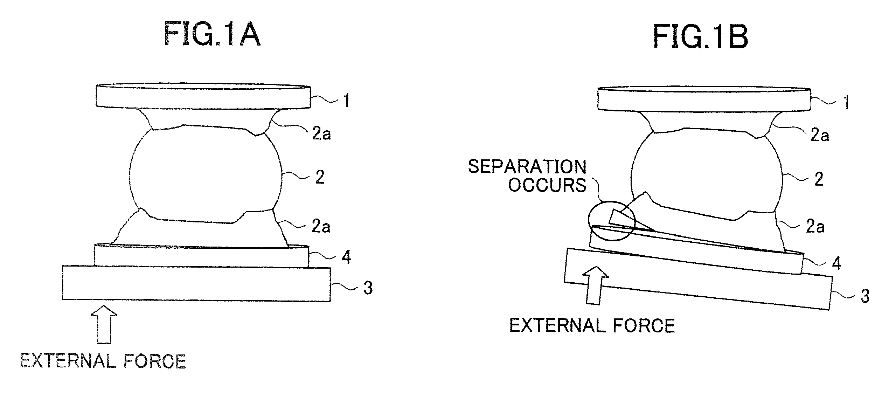

Here, referring to FIGS. 1A and 1B, a description is made of deformation of a solder bump when an external force is applied to a solder bump bonding part as a mounting structure. FIG. 1A illustrates the mounting structure in which an electrode pad 1 of a semiconductor device is bonded to a connection pad 4 of a circuit board 3 by the solder bump 2. The solder bump 2 is melted and solidified at the time of solder reflow, so that solder bonding parts 2a in close contact with the electrode pad 1 and the connection pad 4 are formed. FIG. 1A illustrates a state in which an external force is not applied to the solder bump 2 and the solder bump 2 is not deformed.

When an external force is applied to a part of the circuit board 3 as illustrated in FIG. 1A, the circuit board 3 is deformed in such a manner as to raise its part to which the external force is applied while the solder bump 2 is also deformed as illustrated in FIG. 1B. Since the part to which the external force is applied is away from the center of the solder bump 2, stress is concentrated on the end of the solder bonding part 2a on the side closer to the part to which the external force is applied. When the application of the external force is stopped, the stress is also no longer applied. As a result, the solder bump 2 becomes free from its deformed state and restores its original shape illustrated in FIG. 1A.

If such an external force is repeatedly applied to the circuit board 3, the stress is repeatedly concentrated between the solder bonding part 2a and the connection pad 4, which in turn may separate the end of the solder bonding part 2a from the connection pad 4. Further, if the separation of the end of the solder bonding part 2a is transmitted into the solder bonding part 2a and the connection pad 4, an electrical connection between the solder bonding part 2a and the connection pad 4 is lost, which results in the occurrence of a poor connection.

Further, for example, where the semiconductor device has a base material formed of silicon and the circuit board 3 has a base material formed of a glass epoxy resin, there is a great difference in thermal expansion coefficient between them and thus thermal stress occurs in their bonding parts (solder bumps). If the thermal stress due to the difference in thermal expansion coefficient repeatedly occurs, cracks are caused in the bonding parts (solder bumps) on the side closer to the semiconductor device, which results in the occurrence of poor connections.

In view of the above problems, there has been employed a method of filling an underfill material in a part between mounted semiconductor devices and a circuit board to strengthen solder bonding parts. In other words, the underfill material formed of an epoxy resin or the like is filled around the solder bonding parts to be strengthened at their peripheries, and the bottom surfaces of the semiconductor devices and the front surface of the circuit board are bonded together by the underfill material so as to be mechanically fixed. Thus, the pressure resistance and long-term reliability of the solder bonding parts are improved.

Meanwhile, with recent progress in miniaturization and functional capability of, particularly, electronic devices such as mobile computers including notebook computers and mobile phones, pressure applied to the housings of the electronic devices is easily transmitted to their inner circuit boards and mounting structures. Therefore, in order to further improve the pressure resistance and long-term reliability of solder bonding parts, an underfill material having increased bonding strength and a higher Young's modulus is used. However, if the bonding strength of the underfill material is increased, it becomes difficult to remove semiconductor devices fixed by the underfill material from a circuit board.

For example, if a malfunction occurs in the semiconductor devices after the semiconductor devices are mounted on the circuit board, it is not possible to remove and replace only the semiconductor device in which the malfunction occurs from the circuit board. Accordingly, the expensive circuit board must be replaced in its entirety, which results in an increase in the spoilage cost of the circuit board. In addition, it is not possible to examine the functions of only the semiconductor device assumed to have the malfunction and analyze a reason for the malfunction. Therefore, the reason for the malfunction cannot be determined, which in turn may increase a defective fraction.

In order to address the above problems, there have been proposed mounting structures (see, for example, Patent Documents 1 through 3) in which resilient bodies such as coil springs are inserted between the electrodes of mounted electronic components and the connection electrodes of a circuit board to relax stress.

Patent Document 1: Japanese Laid-open Patent Publication No. 2002-151550

Patent Document 2: Japanese Laid-open Patent Publication No. 2004-140195

Patent Document 3: Japanese Laid-open Patent Publication No. 2009-211133

Since the mounting structures disclosed in Patent Documents 1 through 3 have the coil springs bonded to the numerous electrodes of the electronic components, they are not suitable for fine mounting structures. In other words, it is difficult to provide the fine coil springs for the numerous electrodes one by one, and the mounting structures disclosed in Patent Documents 1 through 3 cannot be applied to recent semiconductor devices having high-density and miniaturized electrodes.

Therefore, it has been desired to develop a mounting structure capable of improving the pressure resistance and long-term reliability of the bonding parts of semiconductor devices without using an underfill material and capable of easily removing the mounted semiconductor devices from a circuit board.

### SUMMARY

According to an aspect of the present invention, there is provided a mounting structure for mounting an electronic component on a circuit board. The mounting structure includes an interposer provided between the electronic component and the circuit board; and a plurality of spiral conductors formed in the interposer. The plurality of spiral conductors have one end thereof bonded to corresponding one of external connection terminals of the electronic component and the other end thereof bonded to corresponding one of electrodes of the electronic component.

According to an embodiment of the present invention, since a plurality of spiral conductors and a interposer are elastically deformable, they are deformed in accordance with stress. Thus, the stress occurring in a bonding part is relaxed, excessive stress does not occur in the bonding part, and cracks caused in the bonding part are prevented. Accordingly, there is no need to fix an electronic component to a circuit board with an underfill material and the mounted electronic component can be easily removed from the circuit board.

The object and advantages of the present invention will be realized and attained by means of the elements and combinations particularly pointed out in the claims.

It is to be understood that both the foregoing general description and the following detailed description are exemplary and explanatory and are not restrictive of the present invention, as claimed.

### BRIEF DESCRIPTION OF DRAWINGS

FIGS. 1A and 1B are views illustrating deformation of a solder bump when an external force is applied to a solder bump bonding part as a mounting structure;

FIG. 2 is a view for explaining a state where cracks are caused due to thermal stress occurring in the solder bump bonding parts;

FIG. 3 is a cross-sectional view illustrating a part of a semiconductor device having a mounting structure according to an embodiment;

FIG. 4 is a view illustrating a state of the mounting structure where an external force is applied to a circuit board on which the semiconductor device illustrated in FIG. 3 is mounted;

FIG. 5 is a view illustrating a deformed state of an interposer including spiral conductors when thermal stress occurs in the mounting structure illustrated in FIG. 4;

FIGS. 6A through 6E are views illustrating a method of forming the spiral conductors embedded in the interposer;

FIG. 7 is a table illustrating the properties and sizes of parts used in the mounting structure;

FIGS. 8A and 8B are views illustrating stress analysis models where an external force is applied;

FIGS. 9A and 9B are views illustrating stress analysis models where thermal stress is applied;

FIG. 10 is a view illustrating the mounting structure where the spiral conductors embedded in the interposer are provided on the circuit board;

FIG. 11 is a view where the interposer in which the spiral conductors are formed is a single unit as a stress relaxation member and the semiconductor device is mounted on the circuit board;

FIG. 12 is a view illustrating the mounting structure where the semiconductor device is mounted on the circuit board using the stress relaxation member provided with external connection terminals; and

FIG. 13 is a perspective view of a notebook computer that incorporates a board assembly on which the semiconductor devices are mounted using the stress relaxation members.

### DESCRIPTION OF EMBODIMENTS

Next, referring to the accompanying drawings, an embodiment of the present invention is described.

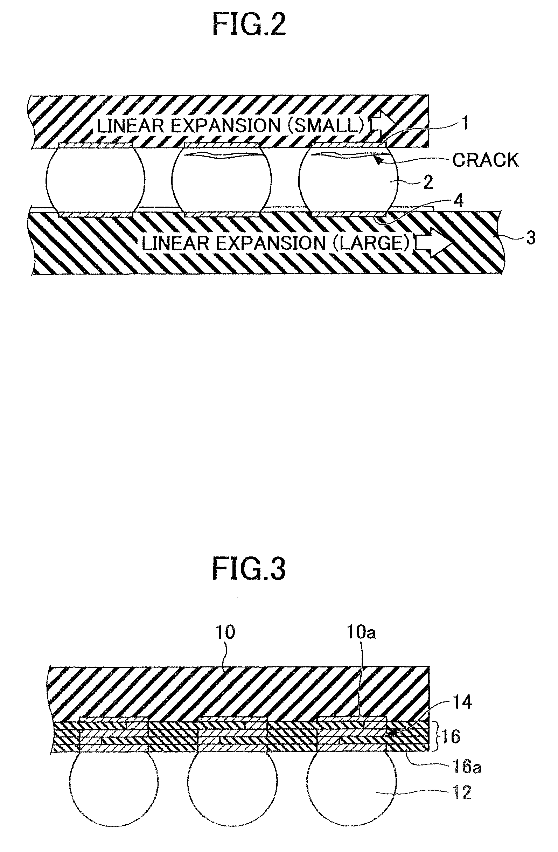

FIG. 3 is a cross-sectional view illustrating a part of a semiconductor device having a mounting structure according to the embodiment. The mounting structure according to this embodiment has spiral conductors 14 formed between electrodes 10a of the semiconductor 10 in, for example, a BGA package and solder bumps (solder balls) 12 as external connection terminals. The spiral conductors 14 are formed of a conductive material, for example, like copper. The spiral conductors 14 have their one end connected to corresponding one of the electrodes 10a of the semiconductor 10 and the other end connected to corresponding one of the solder bumps 12.

The spiral conductors 14 are formed in a laminated body 16 of a resinous insulation sheet 16a as described below. Accordingly, the spiral conductors 14 are elastically deformable (compressible and expandable) together with the laminated body 16 of the resinous insulation sheet 16a. Thus, stress applied to the solder bumps 12 by an external force and thermal stress due to a difference in thermal expansion coefficient can be relaxed, which in turn makes it possible to reduce damage on the bonding parts of the solder bumps 12.

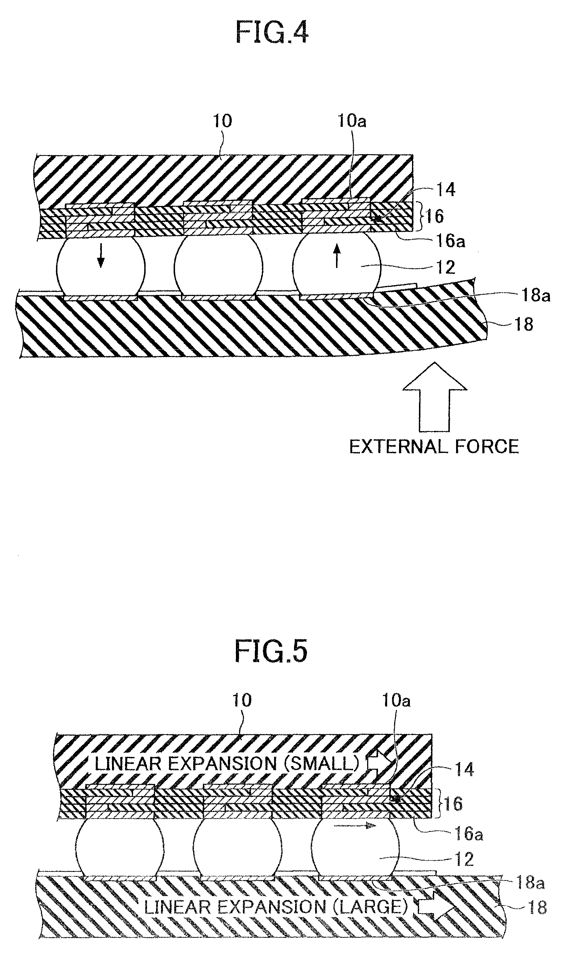

FIG. 4 is a view illustrating a state of the mounting structure where an external force is applied to a circuit board on which the semiconductor device 10 illustrated in FIG. 3 is mounted. The solder bumps 12 of the semiconductor device 10 are bonded to connection electrodes 18a of the circuit board 18. Accordingly, the electrodes 10a of the semiconductor device 10 are connected to the connection electrodes 18a of the circuit board 18 via the solder bumps 12 and the spiral conductors 14.

Here, when an external force is applied to a part of the circuit board 18 as illustrated in FIG. 4, a compression force is applied to the solder bumps 12 on the side closer to the external force while a tensile force is applied to the solder bumps 12 on the side distant from the external force. If the semiconductor device 10 and the circuit board 18 are bonded together only by the solder bumps 12, the compression force and the tensile force directly turn into compression stress and tensile stress, respectively, of the solder bumps 12. As a result, large stress occurs in the solder bumps 12.

In this embodiment, however, the interposer 16 including the elastically deformable spiral conductors 14 is provided between the solder bumps 12 and the semiconductor device 10. When the spiral conductors 14 and the interposer 16 are elastically deformed, the stress occurring in the solder bumps 12 can be relaxed. In other words, the compression stress occurring in the solder bumps 12 is relaxed in such a manner that the spiral conductors 14 and the interposer 16 are compressed to be elastically deformed. On the other hand, the tensile stress occurring in the solder bumps 12 is relaxed in such a manner that the spiral conductors 14 and the interposer 16 are pulled to be elastically deformed.

FIG. 5 is a view illustrating a deformed state of the interposer 16 including the spiral conductors 14 when thermal stress occurs in the mounting structure illustrated in FIG. 4. Where the semiconductor device 10 has a base material formed of silicon and the circuit board 18 has a base material of glass epoxy, the thermal expansion coefficient of the circuit board 18 is much greater than that of the semiconductor device 10. Accordingly, the circuit board 18 expands in a degree greater than the semiconductor device 10. Particularly, near the outer periphery of the semiconductor device 10, displacement (expansion deformation) of the semiconductor device 10 becomes much greater than that of the circuit boared 18. As a result, the thermal stress as indicated by arrow in FIG. 5 occurs in the mounting structure.

In this embodiment, since the spiral conductors 14 and the interposer 16 are elastically deformable in a lateral direction (thermal stress direction), they are deformed in the lateral direction in accordance with the thermal stress. Thus, the thermal stress in the solder bumps 12 is relaxed, excessive stress does not occur in the solder bumps 12, and cracks caused in the solder bumps 12 are prevented. Accordingly, when electronic components such as semiconductor devices are mounted on a circuit board using the mounting structure according to this embodiment, there is no need to fix the electronic components with an underfill material and the mounted electronic components can be easily removed from the circuit board.

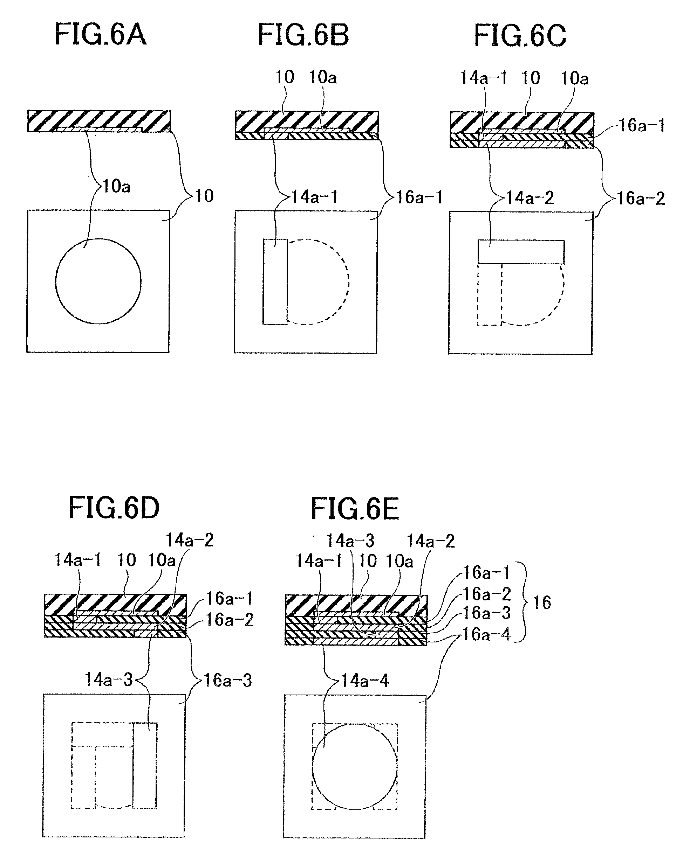

Here, a method of forming the spiral conductors 14 is described. According the method described below, the spiral conductors 14 can be provided for the respective plurality of electrodes 10a of the semiconductor device 10 in a lump sum. FIGS. 6A through 6E are views illustrating the method of forming the spiral conductors 14 embedded in the interposer 16. In each of FIGS. 6A through 6E, only a part including the electrode 10a of the semiconductor device 10 is illustrated, and a cross-sectional view of the spiral conductor 14 and a plan view thereof are illustrated on its upper side and lower side, respectively.

First, the semiconductor device 10 having the electrode 10a as illustrated in FIG. 6A is prepared. The electrode 10a may have an outer diameter of, for example, 300 µm, but the outer diameter of the electrode 10a is not limited to this value. Then, a first insulation sheet 16a-1 having a thickness of, for example, 50 µm is formed on the front surface of the semiconductor 10 including the front surface of the electrode 10a. The first insulation sheet 16a-1 is formed in such a manner that a photosensitive polyimide film is, for example, attached to the front surface of the semiconductor device 10. Next, as illustrated in FIG. 6B, after a part of the polyimide film is cut into a strip shape and removed by photoetching, copper is, for example, plated into the part to form a first copper plate 14a-1 in the first insulation sheet 16a-1. The first copper plate 14a-1 has a width of, for example, 50 µm and a length of about, 300 µm, but the width and the length of the first copper plate 14a-1 are not limited to these values.

Then, a second insulation sheet 16a-2 is laminated on the first insulation sheet 16a-1 including the front surface of the first copper plate 14a-1. The second insulation sheet 16a-2 is formed in such a manner that a photosensitive polyimide film similar to the first insulation sheet 16a-1 is attached to the first insulation sheet 16a-1. Next, as illustrated in FIG. 16C, after a part of the polyimide film is cut into a strip shape and removed by photoetching, copper is, for example, plated into the part to form a second copper plate 14a-2 as a conductive part in the second insulation sheet 16a-2. At this time, a strip-shaped opening formed in the first insulation sheet 16a-2 is such that it has its one end overlapped with the first copper plate 14a-1 formed in the first insulation sheet 16a-1 and extends in a direction in which the first copper plate 14a-1 is rotated by 90 degrees relative to its longitudinal direction. Accordingly, the strip-shaped second copper plate 14a-2 formed in the second insulation sheet 16a-2 has its one end bonded to one end of the first copper plate 14a-1 and extends in the direction in which the first copper plate 14a-1 is rotated by 90 degrees relative to the longitudinal direction. The second copper plate 14a-2 has a width of, for example, 50 µm and a length of, for example, 300 µm, but the width and the length of the second copper plate 14a-2 are not limited to these values.

Then, a third insulation sheet 16a-3 is laminated on the second insulation sheet 16a-2 including the front surface of the second copper plate 14a-2. The third insulation sheet 16a-3 is formed in such a manner that a photosensitive polyimide film similar to the first insulation sheet 16a-1 is attached to the second insulation sheet 16a-2. Next, after a part of the polyimide film is cut into a strip shape and removed by photoetching, copper is, for example, plated into the part to form a third copper plate 14a-3 as a conductive part in a third insulation sheet 16a-3. At this time, a strip-shaped opening formed in the third insulation sheet 16a-3 is such that it has its one end overlapped with the second copper plate 14a-2 formed in the second insulation sheet 16a-2 and extends in a direction in which the second copper plate 14a-2 is rotated by 90 degrees relative to its longitudinal direction. Accordingly, the strip-shaped third copper plate 14a-3 formed in the third insulation sheet 16a-3 has its one end bonded to one end of the second copper plate 14a-2 and extends in the direction in which the second copper plate 14a-2 is rotated by 90 degrees relative to the longitudinal direction. The third copper plate 14a-3 has a width of, for example, 50 µm and a length of, for example, 300 µm, but the width and the length of the third copper plate 14a-3 are not limited to these values.

Then, a fourth insulation sheet 16a-4 is laminated on the third insulation sheet 16a-3 including the front surface of the third copper plate 14a-2. The fourth insulation sheet 16a-4 is formed in such a manner that a photosensitive polyimide film similar to the first insulation sheet 16a-1 is attached to the third insulation sheet 16a-3. Next, as illustrated in FIG. 6E, after a part of the polyimide film is cut into a circle and removed by photoetching, copper is, for example, plated into the part to form a fourth copper plate 14a-4 as a conductive part in the fourth insulation sheet 16a-4. At this time, a circular opening formed in the fourth insulation sheet 16a-3 is such that it is overlapped with the second copper plate 14a-3 formed in the third insulation sheet 16a-3 and placed at the same position as the electrode 10a of the semiconductor device 10. Accordingly, the circular copper plate 14a-4 formed in the fourth insulation sheet 16a-4 is bonded to the entire surface of the third copper plate 14a-3. The fourth copper plate 14a-4 is formed of an electrode pad and is the circle having a diameter of, for example, 300 µm, but the diameter of the fourth copper plate 14a-4 is not limited to this value.

In the method described above, the spiral conductor 14 embedded in the interposer 16 can be formed. Then, the solder bumps 12 is formed on the circular fourth copper plate 14a-4 (electrode pad) of the spiral conductors 14 and used as an external connection terminal of the semiconductor device 10.

Note that in the above method, the strip-shaped first through third copper plates 14a-1 through 14a-3 are connected together to form the spiral conductors 14. However, the shapes of the first through third copper plates 14a-1 through 14a-3 are not limited to strips but may be, for example, circular arcs each having a length of 1/4 of a circumference.

Further, in the above method, the spiral conductor 14 is formed of copper. However, the material of the spiral conductor 14 is not limited to copper but may be, for example, nickel and other metal having a relatively high Young's modulus.

Further, in the above method, the polyimide films are used as the insulation sheets 16a-1 through 16a-4. However, the insulation sheets 16a-1 through 16a-4 are not limited to the polyimide films, but other insulation sheets such as silicon sheets having heat resistance and elasticity may be used.

Next, results of stress analyses with respect to the above mounting structure are described.

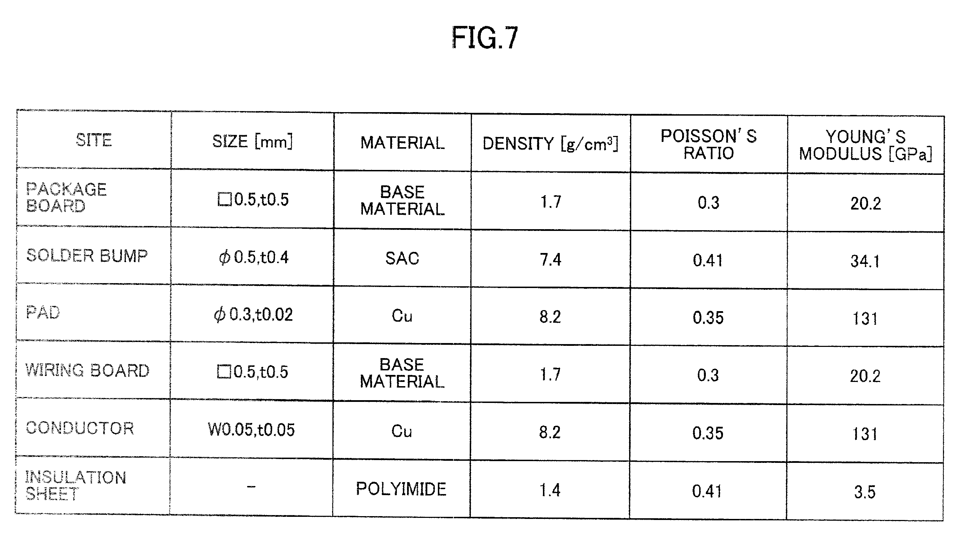

First, the properties and sizes of parts used in the mounting structure were set as illustrated in FIG. 7. In FIG. 7, "package board" corresponds to the base material of the semiconductor device 10, and "solder bump" refers to the solder bumps 12. Further, "pad" corresponds to the electrodes 10a of the semiconductor device 10 and the connection electrodes 18a of the circuit board 18, and "wiring board" corresponds to the base material of the circuit board 18. Further, "conductor (copper)" corresponds to the spiral conductors 14, and "insulation sheet" corresponds to the interposer 16. The mounting structure was formed using the above parts, and maximum stress occurring in the solder bumps was found according to the analysis of the structure.

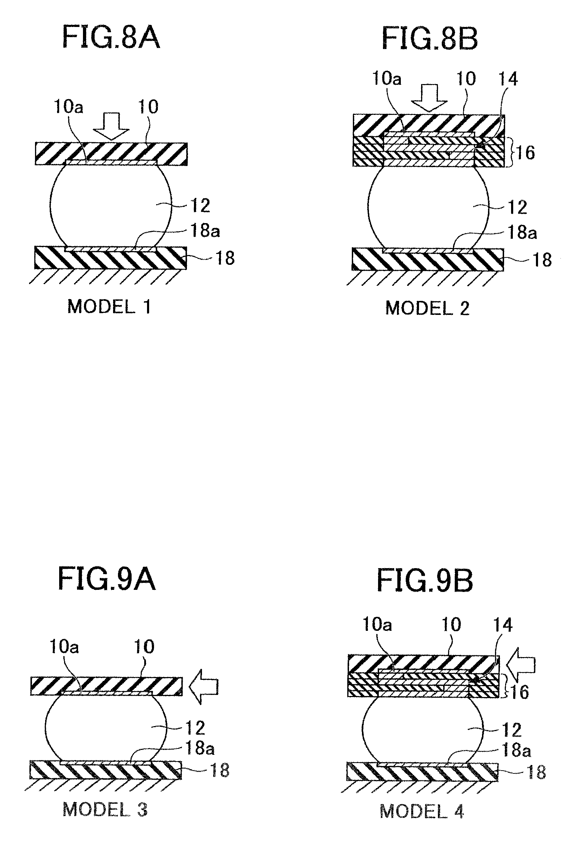

The stress analysis was carried out assuming that a case in which an external force was applied to a normal mounting structure as illustrated in FIG. 8A was specified as model 1 while a case in which an external force was applied to the mounting structure having the spiral conductors 14 embedded in the interposer 16 according to this embodiment as illustrated in FIG. 8B was specified as model 2.

As a stress analysis condition, a reference external force was applied to the semiconductor devices 10 of the models 1 and 2. The size of the external force was such that a distance between the semiconductor device 10 and the circuit board 18 decreased by 10 µm when the mounting structure of the model 2 was compressed. As a result of the stress analysis, it turned out that the maximum value of the stress occurring in the solder bump 12 was 889 Mpa in the model 1 as the normal mounting structure. On the other hand, it turned out that the maximum value of the stress occurring in the solder bump 12 was 350 MPa in the model 2 as the mounting structure according to this embodiment.

As is generally known, cracks would be caused in the solder bump 12 if 500 MPa or more of stress is repeatedly applied to the solder bump 12 by an external force. Accordingly, it was confirmed that cracks would be caused in the solder bump 12 in the model 1 of the normal mounting structure while cracks would be hardly caused in the model 2 of the mounting structure according to this embodiment.

Further, the stress analysis was carried out assuming that a case in which thermal stress occurred in a normal mounting structure as illustrated in FIG. 9A was specified as model 3 while a case in which thermal stress occurred in the mounting structure having the spiral conductors 14 embedded in the interposer 16 according to this embodiment as illustrated in FIG. 9B was specified as model 4. At this time, the package board had a base material formed of ceramic (thermal expansion coefficient α1 = 7 ppm), while the circuit board had a base material formed of a heat-resistant glass epoxy resin laminated plate (thermal expansion coefficient α2 = 25 ppm).

Assuming that the package board and the circuit board were quadrilaterals each having a side of 20 mm and held at 125°C, a maximum deformation amount (maximum distortion) emerged at their outermost peripheries, which was expressed by the formula λ = εL = (α1 - α2) ΔT·L = (25 - 7) · 10⁻⁶ · 100 · 100 mm = 0.018 mm (18 µm). In this formula, ε indicates a difference in thermal expansion coefficient, ΔT indicates a temperature rise value, and L indicates a distance between the center of the package board and the outermost periphery thereof. Under this conditions, the models 3 and 4 were constrained in their lateral directions to carry out the stress analysis to find maximum stress occurring in the solder bumps.

As a result of the stress analysis, it turned out that that the maximum value of the stress occurring in the solder bump 12 was 619 MPa in the model 3 as the normal mounting structure. On the other hand, it turned out that the maximum value of the stress occurring in the solder bump 12 was 377 MPa in the model 4 as the mounting structure according to this embodiment. As is generally known, cracks would be caused in the solder bump 12 if 500 MPa or more of stress is repeatedly applied to the solder bump 12 by thermal stress. Accordingly, it was confirmed that cracks would be caused in the solder bump 12 in the model 3 of the normal mounting structure while cracks would be hardly caused in the model 4 of the mounting structure according to this embodiment.

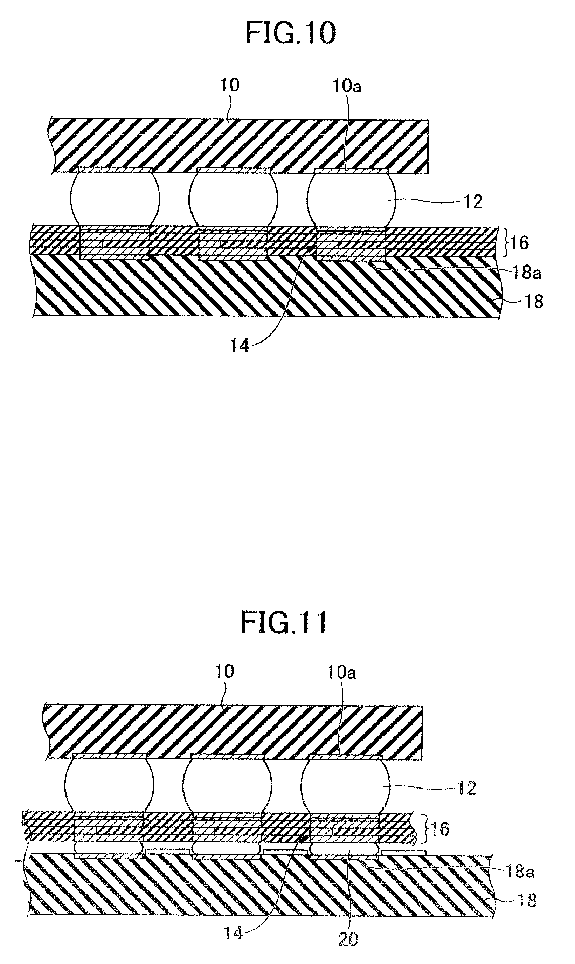

In the above embodiment, the spiral conductors 14 embedded in the interposer 16 are inserted between the electrodes 10a of the semiconductor device 10 and the solder bumps 12 as stress relaxation (alleviation) members. However, the stress relaxation members may be formed on the side of the circuit board 18. FIG. 10 is a view illustrating the mounting structure where the spiral conductors 14 embedded in the interposer 16 are provided on the circuit board 10.

In FIG. 10, the interposer 16 is formed on the front surface of the circuit board 18 including the front surfaces of the electrodes 18a, and the spiral conductors 14 in the interposer 16 have their one end connected to corresponding one of the connection electrodes 18a of the circuit board 18. Accordingly, the fourth copper plates 14a-4 at the outermost parts of the spiral conductors 14 function as the connection electrodes of the circuit board 18. In FIG. 10, the solder bumps 12 of the semiconductor device 10 are bonded to the fourth copper plates 14a-4 at the outermost parts of the spiral conductors 14, whereby the semiconductor device 10 is mounted on the circuit board 18.

Further, the interposer 16 in which the spiral conductors 14 are formed may be a single unit as the stress relaxation member. FIG. 11 is a view where the interposer 16 in which the spiral conductors 14 are formed is the single unit as the stress relaxation member and inserted between the semiconductor device 10 and the circuit board 18. In order to form the single-unit interposer 16 in which the spiral conductors 14 are formed, a base material with which the interposer 16 is easily separated is first prepared. Then, the interposer 16 and the spiral conductors 14 are formed on the base material according to the method described in FIGS. 6A through 6E. After that, the base material is separated and removed. The base material may be removed by etching rather than being separated.

FIG. 11 illustrates a state where the spiral conductors 14 in the single-unit insulation laminated body 16 have their one end bonded to corresponding one of the connection electrodes 18 of the circuit board 18 by a soldering paste and have the other end bonded to corresponding one of the solder bumps 12 of the semiconductor device 10.

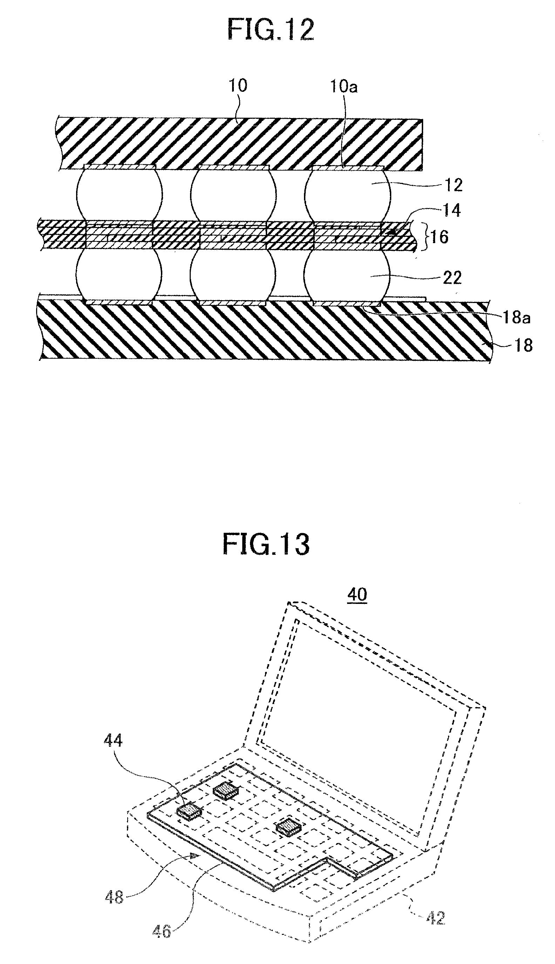

Furthermore, as illustrated in FIG. 12, the interposer 16 in which the spiral conductors 14 are formed may be a single unit as the stress relaxation member, wherein the spiral conductors have their one end provided with corresponding one of the solder bumps 22. In other words, the stress relaxation member illustrated in FIG. 12 has the solder bumps 22 with which the semiconductor device 10 is bonded to the circuit board 18.

The interposer 16 including the spiral conductors 14 as the stress relaxation members according to this embodiment is used when electronic components such as semiconductor devices are mounted on a circuit board incorporated in an electronic device. FIG. 13 is a perspective view of a notebook computer that incorporates a board assembly 48 on which semiconductor devices 44 are mounted using the stress relaxation members according to this embodiment.

A main body 42 having the keyboard of the notebook computer 40 incorporates the board assembly 48 in which the semiconductor devices 44 are mounted on a circuit board 46. In mounting the semiconductor devices 44 on the circuit board 46, the insulation sheet laminated bodies 16 including the spiral conductors 14 as the stress relaxation members according to this embodiment are used. Since the notebook computer 40 is thin, a force applied from an outside to the main body 42 is easily transmitted to the circuit board 46 to easily bring the circuit board 46 into a deformed state. Accordingly, the stress relaxation members according to this embodiment can relax stress occurring in the bonding parts of the mounting structure of the notebook computer 40 and improve the pressure resistance and long-term reliability of the bonding parts between the semiconductor devices and the circuit board 46.

Note that this embodiment is described using solder as a bonding material. However, the bonding material is not limited to solder, and other thermofusion materials may be used. Further, copper is used as the material of the spiral conductors 14, but nickel and other metal having a high Young's modulus may be used.

## Claims

1. A mounting structure for mounting an electronic component on a circuit board, the mounting structure comprising:
an interposer provided between the electronic component and the circuit board; and
a plurality of spiral conductors formed in the interposer; wherein
the plurality of spiral conductors have one end thereof bonded to corresponding one of external connection terminals of the electronic component and the other end thereof bonded to corresponding one of electrodes of the electronic component.

2. The mounting structure according to claim 1, wherein
the interposer includes laminated insulation sheets.

3. The mounting structure according to claim 1, wherein
each of the spiral conductors includes conductive parts connected to one another in the interposer.

4. The mounting structure according to claim 2, wherein
the insulation sheets are formed of polyimide or silicon.

5. The mounting structure according to claim 3, wherein
the conductive parts are formed of copper.

6. An electronic component comprising the mounting structure according to claim 1.

7. A circuit board comprising the mounting structure according to claim 1.

8. A board assembly comprising:
a circuit board; and
an electronic component mounted on the circuit board via the mounting structure according to claim 1.

9. An electronic device incorporating the board assembly according to claim 8.

10. A stress relaxation member provided between an electronic component and a circuit board, the stress relaxation member comprising:
an interposer formed by laminating a plurality of insulation sheets together; and
a plurality of spiral conductors formed in the interposer.

11. The stress relaxation member according to claim 10, wherein
each of the spiral conductors includes conductive parts connected to one another in the interposer.

12. The stress relaxation member according to claim 10, wherein
the interposer includes laminated insulation sheets.

13. The stress relaxation member according to claim 12, wherein
the insulation sheets are formed of polyimide or silicon.

14. The stress relaxation member according to claim 11, wherein
the conductive parts are formed of copper.
